# EUROPÄISCHE PATENTANMELDUNG

(11) **EP 1 521 312 A2**
(43) Veröffentlichungstag der Anmeldung: **06.04.2005**
(21) Anmeldenummer: 04022979.1
(22) Anmeldetag: 27.09.2004
(51) Int. Cl.: H01L 33/00, H01L 21/60

(54) **Optoelektronisches Bauelement mit einem metallisierten Träger**

(30) Priorität: 14.10.2003 DE 10347737; 30.09.2003 DE 10345415
(71) Anmelder: Osram Opto Semiconductors GmbH, 93049 Regensburg (DE)
(72) Erfinder: Winter, Matthias, 93059 Regensburg (DE); Bogner, Georg, 93138 Lappersdorf (DE); Gruber, Stefan, 93077 Bad Abbach (DE)
(74) Vertreter: Epping Hermann & Fischer

(57) **Zusammenfassung**

Bei einem optoelektronischen Bauelement mit einem Halbleiterkörper (1), der ein Substrat (2) und ein auf dem Substrat (2) abgeschiedenes Schichtsystem (3) enthält, wobei der Halbleiterkörper (1) mit einer dem Substrat (2) gegenüberliegenden Hauptfläche mittels einer Lötverbindung (7) auf einem Träger (4) befestigt ist, und der Träger (4) auf der dem Halbleiterkörper (1) zugewandten Seite eine Metallisierung 5 aufweist, ist die Metallisierung (5) gemäß der Erfindung frei von Silber. Weiterhin betrifft die Erfindung ein optoelektronisches Bauelement mit einem Dünnfilm-Halbleiterkörper (8), der mittels einer Lötverbindung (7) auf einem Träger (4) befestigt ist, und der Träger (4) auf der dem Halbleiterkörper (8) zugewandten Seite eine Metallisierung (5) aufweist, wobei die Metallisierung (5) gemäß der Erfindung frei von Silber ist.

## Beschreibung

Die Erfindung betrifft ein optoelektronisches Bauelement nach dem Oberbegriff des Patentanspruchs 1 oder des Patentanspruchs 2.

Bei der Herstellung optoelektronischer Bauelemente in Dünnfilm-Technologie wird ein Halbleiterschichtsystem zunächst auf einem Aufwachssubstrat aufgewachsen, anschließend auf einen neuen Träger aufgebracht und dann das Aufwachssubstrat abgetrennt. Unter dem verbleibenden Halbleiterschichtsystem wird im Rahmen der Erfindung ein Dünnfilm-Halbleiterkörper verstanden. Die Dünnfilm-Technologie hat einerseits den Vorteil, daß Aufwachssubstrate, insbesondere für die Herstellung von Nitridverbindungshalbleitern geeignete Aufwachssubstrate, die vergleichsweise teuer sind, wiederverwendet werden können. Dieses Verfahren hat weiterhin den Vorteil, daß durch das Ablösen des ursprünglichen Substrats dessen Nachteile, wie zum Beispiel eine geringe elektrische Leitfähigkeit und eine erhöhte Absorption der von dem optoelektronischen Bauelement generierten oder detektierten Strahlung, vermieden werden. Dadurch läßt sich die Effizienz von LEDs, insbesondere deren Helligkeit, steigern. Eine derartige LED ist beispielsweise aus der WO 02/084749 bekannt, deren Inhalt hiermit durch Referenz aufgenommen wird.

Eine weitere Technologie zur Herstellung von hocheffizienten LEDs stellt die sogenannte Flip-Chip-Technologie dar. Ein derartiges Bauelement wird beispielsweise in der WO 01/47039 A1 offenbart. Hierin wird ein strahlungsemittierender Halbleiterchip beschrieben, der mit der dem Aufwachssubstrat der Halbleiterschichten gegenüberliegenden Seite auf einem Träger befestigt ist.

Bei optoelektronischen Bauelementen in Dünnfilmtechnologie oder Flip-Chip-Technologie, bei denen ein Halbleiterkörper mittels einer Lötverbindung auf einem Trägerkörper, bei dem es sich beispielsweise um einen Leiterrahmen (Leadframe) oder einen Submount (z.B. einen Halbleiterwafer) handeln kann, befestigt wird, werden oftmals Trägerkörper verwendet, auf deren Oberfläche eine geeignete Metallisierungsschicht zur Herstellung einer Lötverbindung aufgebracht ist.

Als Träger werden beispielsweise Leiterrahmen aus dem Grundmaterial Kupfer, die mit einer Metallisierung aus Silber versehen sind, verwendet. Es hat sich gezeigt, daß bei derartigen Bauelementen im Leistungsbetrieb eine erhöhte Gefahr eines Kurzschlusses der funktionellen Schichten besteht. Weiterhin besteht die Gefahr mechanisch instabiler Lötverbindungen.

Der Erfindung liegt die Aufgabe zugrunde, ein optoelektronisches Bauelement in Dünnfilm- und/oder Flip-Chip-Technologie anzugeben, das sich durch eine erhöhte Zuverlässigkeit auszeichnet. Insbesondere soll eine verbesserte Metallisierung des Trägers angegeben werden.

Diese Aufgabe wird gemäß der Erfindung durch ein optoelektronisches Bauelement nach Patentanspruch 1 oder nach Patentanspruch 2 gelöst.

Bei einem optoelektronischen Bauelement mit einem Halbleiterkörper, der ein Substrat und ein auf dem Substrat abgeschiedenes Halbleiterschichtsystem enthält, wobei der Halbleiterkörper mit einer dem Substrat gegenüberliegenden Hauptfläche mittels eine Lötverbindung auf einem Träger befestigt ist beziehungsweise bei einem optoelektronischem Bauelement mit einem Dünnfilmhalbleiterkörper, der mittels einer Lötverbindung auf einem Träger befestigt ist, weist der Träger auf der dem Halbleiterkörper zugewandten Seite eine Metallisierung auf, die gemäß der Erfindung frei von Silber ist.

Bei mit Silber beschichteten Leiterrahmen besteht bei der Verwendung für ein in Flip-Chip-Technologie montiertes Bauelement oder ein Bauelement in Dünnfilmtechnologie die Gefahr, daß die Silberschichten aufgrund der räumlichen Nähe zu den funktionellen Halbleiterschichten des Halbleiterkörpers hohen elektrischen Feldstärken ausgesetzt sind, was zu einer Silbermigration führen kann. Durch die Silbermigration kann es zu einem Kurzschluß des optoelektronischen Bauelements kommen. Weiterhin kann die Migration von Silber nachteilig bewirken, daß in der Lotschicht eine silberreiche Phase entsteht, die mechanisch instabil ist und deshalb zu einer Unterbrechung des Kontakts führen kann.

Durch die silberfreie Metallisierung werden zuvor beschriebenen Probleme, die durch Silbermigration auftreten können, vorteilhaft vermieden. Als frei von Silber werden im Rahmen der Erfindung auch Metallisierungen angesehen, bei denen aufgrund von Verunreinigungen noch Spuren von Silber nachweisbar sind, die aber in Bezug auf die Problematik der Silbermigration praktisch nicht von Bedeutung sind. Der maximal tolerierbare Silberanteil kann beispielsweise durch Lebensdauer-Tests nachgewiesen werden, insbesondere durch Betrieb in hoher Feuchte oder durch Stromzykeltests.

Die Metallisierung enthält bevorzugt Ni, NiAu, NiPAu, NiP oder TiPt. Die Dicke der Metallisierung beträgt vorteilhaft 0,2 µm bis 10 µm, besonders bevorzugt 2 µm bis 4 µm. Neben der Silberfreiheit zeichnen sich die genannten Materialien auch durch ihre gute Verarbeitbarkeit bezüglich der Herstellung der Lötverbindung zum Halbleiterkörper oder zur Anbringung eines Drahtbonds zur Kontaktierung des optoelektronischen Bauelements nach außen aus.

Um insbesondere eine Oxidation der Metallisierung zu vermeiden, ist vorzugsweise eine Goldschicht auf die Metallisierung aufgebracht. Die Dicke der Goldschicht beträgt vorteilhaft 0,05 µm bis 1 µm, besonders bevorzugt 0,15 µm bis 0,30 µm. Die Goldschicht kann beispielsweise galvanisch abgeschieden sein, wobei es vorteilhaft sein kann, nur die zur Herstellung einer Lötverbindung vorgesehenen Bereiche des Trägers mit einer Metallisierung und der Goldschicht zu versehen, um Kosten einzusparen.

Der Träger ist beispielsweise ein Leiterrahmen. Der Leiterrahmen ist zum Beispiel mit einem Chipgehäuse umformt. Das Chipgehäuse besteht bevorzugt aus Kunststoff und kann beispielsweise durch Spritzgießen hergestellt sein.

Weitere geeignete Träger des optoelektronischen Bauelements sind beispielsweise ein Submount, insbesondere ein Halbleiterwafer, oder ein PCB (Printed Circuit Board).

Das optoelektronische Bauelement ist insbesondere ein strahlungsemittierendes Bauelement, beispielsweise eine lichtemittierende Diode oder eine Laserdiode. Besonders vorteilhaft ist die Erfindung für strahlungsemittierende Bauelemente auf der Basis von Nitridverbindungshalbleitern, wobei unter einem Nitridverbindungshalbleiter eine Nitridverbindung von Elementen der dritten und/oder fünften Hauptgruppe, insbesondere GaN, AlGaN, InGaN, AlInGaN, AlN oder InN, verstanden wird. Aufgrund der im Vergleich zu auf anderen Halbleitermaterialien basierenden strahlungsemittierenden Bauelementen höheren Betriebsspannung von 2 V oder mehr ist bei diesen die Gefahr der Silbermigration besonders hoch.

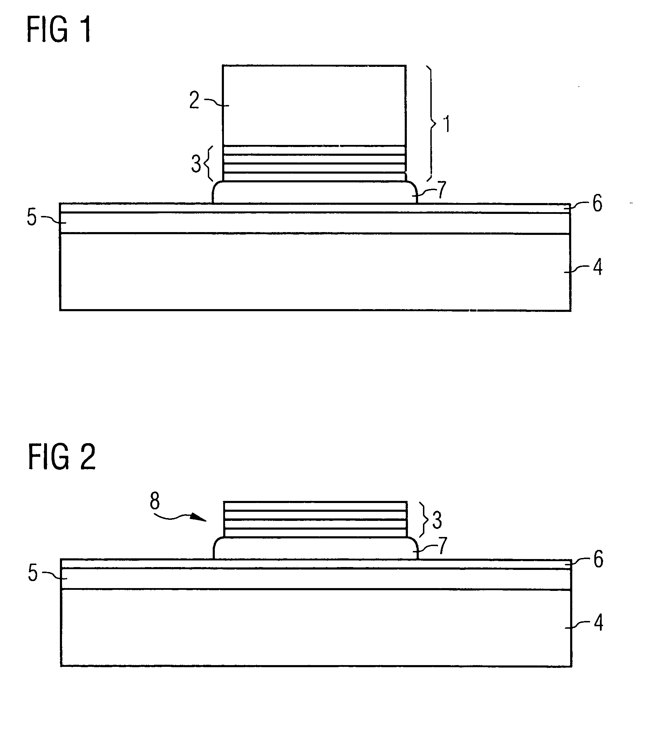

Die Erfindung wird im folgenden anhand von zwei Ausführungsbeispielen im Zusammenhang mit den Figuren 1 und 2 näher erläutert.

### Es zeigen:

- Figur 1: einen schematisch dargestellten Querschnitt durch ein erstes Ausführungsbeispiel der Erfindung und

- Figur 2: einen schematisch dargestellten Querschnitt durch ein zweites Ausführungsbeispiel der Erfindung.

Gleiche oder gleichwirkende Elemente sind in den Figuren mit den gleichen Bezugszeichen versehen.

Das in Figur 1 dargestellte optoelektronische Bauelement enthält eine Halbleiterchip 1, der ein Substrat 2 und ein darauf abgeschiedenes Schichtsystem 3 enthält. Das Substrat 2 ist beispielsweise ein SiC- oder ein Saphirsubstrat. Das Schichtsystem 3 ist insbesondere ein auf dem Substrat 2 epitaktisch abgeschiedenes Halbleiterschichtsystem, das beispielsweise eine strahlungsemittierende aktive Schicht enthält. Insbesondere kann es sich dabei um eine strahlungsemittierende Schicht handeln, die ein III-V-Verbindungshalbleitermaterial, besonders bevorzugt einen Nitridverbindungshalbleiter, enthält.

Mit einer Lötverbindung 7 ist der Halbleiterchip 1 auf einem Träger 4 befestigt. Der Träger 4 ist beispielsweise ein Leiterrahmen, ein Submount oder ein Printed Circuit Board. Um die Lötbarkeit zu gewährleisten, ist der Träger 4 mit einer Metallisierung 5 versehen, die gemäß der Erfindung frei von Silber ist. Besonders geeignete Metallisierungen sind zum Beispiel Ni, NiAu, NiPAu, NiP oder TiPt. Eine derartige Metallisierung 5 vermeidet das Problem der Silbermigration, die einerseits einen Kurzschluß der Halbleiterschichten 3 des optoelektronischen Bauelements und andererseits eine mechanische Instabilität der Lötverbindung 7 durch Ausbildung einer silberreichen Phase innerhalb der Lötverbindung 7.

Die Lötverbindung 7 kann durch ein aus mehreren Schichten bestehendes Kontaktschichtsystem ausgebildet sein. Das Kontaktschichtsystem umfaßt eine Lotschicht, die beispielsweise ein Weichlot, insbesondere in einer eutektischen Zusammensetzung, enthält. Vorzugsweise ist die Lotschicht vor der Herstellung der Lötverbindung auf den Halbleiterkörper 1 aufgebracht. Es ist aber ebenfalls möglich, daß die Lotschicht in strukturierter Form auf dem Träger aufgebracht ist.

Das Kontaktschichtsystem der Lötverbindung 7 kann in einer bevorzugten Ausführung weitere Schichten umfassen, beispielsweise eine den Halbleiterschichten 3 zugewandte Reflektorschicht, eine Barrierenschicht zur Trennung der Reflektorschicht von der Lotschicht, und/oder Schichten, die beispielsweise die Haftung oder die Benetzung der Lotschicht verbessern.

Die Metallisierung 5 des Trägers 4 weist vorzugsweise eine Dicke von 0,2 µm bis 10 µm auf. Vorteilhaft ist die Metallisierung mit einer Goldschicht versehen, deren Dicke 0,05 µm bis 1 µm beträgt. Die Goldschicht 6 ist beispielsweise galvanisch auf die Metallisierung aufgebracht. Mit der Goldschicht 6 wird eine Oxidation der Metallisierung 5 verhindert.

Die Metallisierung 5 und/oder die Goldschicht 6 sind beispielsweise ganzflächig auf den Träger aufgebracht. Alternativ erfolgt das Aufbringen der Metallisierung 5 und/oder der Goldschicht 6 nur auf die zur Herstellung der Lötverbindung vorgesehenen Teilbereiche des Trägers 4. Durch die strukturierte Aufbringung der Metallisierung 5 auf den Träger 4 können voneinander isolierte elektrische Anschlußbereich hergestellt werden, so daß der Halbleiterchip 1 beispielsweise sowohl mit einem n-Kontakt als auch mit einem p-Kontakt jeweils durch eine direkte Lötverbindung mit dem Träger 4 verbunden werden kann.

Das in Figur 2 dargestellte Ausführungsbeispiel der Erfindung unterschiedet sich von dem in Figur 1 dargestellten dadurch, daß der Halbleiterkörper 1 kein Substrat aufweist, sondern lediglich von einem Dünnfilm-Halbleiterkörper 8 aus einem Halbleiterschichtsystem 3 gebildet wird. Der Dünnfilm-Halbleiterkörper 8 ist beispielsweise dadurch hergestellt, daß ein ursprünglich vorhandenes Aufwachssubstrat nach der Herstellung der Lötverbindung des Halbleiterkörpers 8 mit dem Träger 4 abgelöst wurde. Insbesondere kann es sich dabei um einen Halbleiterkörper 8 handeln, der ein Halbleiterschichtsystem 3 aus Nitridverbindungshalbleitern, wie zum Beispiel InGaAlN, enthält, das auf einem Aufwachssubstrat aus Siliziumcarbid oder Saphir hergestellt wurde, und das Aufwachssubstrat anschließend mittels einem Laser-Lift-Off-Verfahren abgelöst wurde. Ansonsten, insbesondere im Bezug auf die Ausgestaltung der Metallisierung 5, entspricht das in Figur 2 dargestellte Ausführungsbeispiel dem in Figur 1 dargestellten ersten Ausführungsbeispiel.

Die Erläuterung der Erfindung anhand der Ausführungsbeispiele ist selbstverständlich nicht als Einschränkung auf diese zu verstehen. Vielmehr umfaßt die Erfindung auch alle anderen offenbarten neuen Merkmale sowohl einzeln als auch in Kombination miteinander, selbst wenn diese nicht Gegenstand eines Patentanspruchs sind.

## Patentansprüche

1. Optoelektronisches Bauelement mit einem Halbleiterkörper (1), der ein Substrat (2) und ein auf dem Substrat (2) abgeschiedenes Schichtsystem (3) enthält, wobei der Halbleiterkörper (1) mit einer dem Substrat (2) gegenüberliegenden Hauptfläche mittels einer Lötverbindung (7) auf einem Träger (4) befestigt ist, und der Träger (4) auf der dem Halbleiterkörper (1) zugewandten Seite eine Metallisierung (5) aufweist,
**dadurch gekennzeichnet, daß** die Metallisierung (5) frei von Silber ist.

2. Optoelektronisches Bauelement mit einem Dünnfilm-Halbleiterkörper (8), der mittels einer Lötverbindung (7) auf einem Träger (4) befestigt ist, und der Träger (4) auf der dem Halbleiterkörper (8) zugewandten Seite eine Metallisierung (5) aufweist,
**dadurch gekennzeichnet, daß** die Metallisierung (5) frei von Silber ist.

3. Optoelektronisches Bauelement nach einem der Ansprüche 1 oder 2,
**dadurch gekennzeichnet, daß** die Metallisierung (5) Ni, NiAu, NiPAu, NiP oder TiPt enthält.

4. Optoelektronisches Bauelement nach einem der vorhergehenden Ansprüche,
**dadurch gekennzeichnet, daß** die Dicke der Metallisierung (5) 0,2 µm bis 10 µm beträgt.

5. Optoelektronisches Bauelement nach einem der vorhergehenden Ansprüche,
**dadurch gekennzeichnet, daß** eine Goldschicht (6) auf die Metallisierung (5) aufgebracht ist.

6. Optoelektronisches Bauelement nach Anspruch 5,
**dadurch gekennzeichnet, daß** die Dicke der Goldschicht (6) 0,05 µm bis 1 µm beträgt.

7. Optoelektronisches Bauelement nach einem der Ansprüche 5 oder 6,
**dadurch gekennzeichnet, daß** die Goldschicht (6) galvanisch aufgebracht ist.

8. Optoelektronisches Bauelement nach einem der vorhergehenden Ansprüche,
**dadurch gekennzeichnet, daß** der Träger (4) ein Leiterrahmen ist.

9. Optoelektronisches Bauelement nach Anspruch 8,
**dadurch gekennzeichnet, daß** der Leiterrahmen mit einem Chipgehäuse umformt ist.

10. Optoelektronisches Bauelement nach einem der Ansprüche 1 bis 7,
**dadurch gekennzeichnet, daß** der Träger (4) ein Submount, insbesondere ein Halbleiterwafer, ist.

11. Optoelektronisches Bauelement nach einem der Ansprüche 1 bis 7,
**dadurch gekennzeichnet, daß** der Träger (4) ein Printed Circuit Board (PCB) ist.

12. Optoelektronisches Bauelement nach einem der vorhergehenden Ansprüche,
**dadurch gekennzeichnet, daß** das optoelektronische Bauelement ein strahlungsemittierendes optoelektronisches Bauelement ist.

13. Optoelektronisches Bauelement nach Anspruch 12,
**dadurch gekennzeichnet, daß** das strahlungsemittierende optoelektronische Bauelement eine strahlungsemittierende aktive Zone aufweist, die ein Nitridverbindungshalbleitermaterial enthält.

14. Optoelektronisches Bauelement nach einem der vorhergehenden Ansprüche,
**dadurch gekennzeichnet, daß** die Betriebsspannung des optoelektronischen Bauelements 2 V oder mehr beträgt.
